# EUROPEAN PATENT APPLICATION

(11) **EP 2 853 617 A1**
(43) Date of publication of application: **01.04.2015**
(21) Application number: 13812655.2
(22) Date of filing: 28.06.2013
(51) Int. Cl.: C23C 14/34

(54) **SPUTTERING TARGET**

(30) Priority: 04.07.2012 JP 2012150548
(71) Applicant: JX Nippon Mining & Metals Corporation, Tokyo 100-8164 (JP)
(72) Inventor: SUZUKI, Ryo, Kitaibaraki-shi Ibaraki 319-1535 (JP); OKABE, Takeo, Kitaibaraki-shi Ibaraki 319-1535 (JP)
(74) Representative: Hoarton, Lloyd Douglas Charles
(86) International application number: PCT/JP2013/067777
(87) International publication number: WO 2014/007151

(57) **Abstract**

Provided is a sputtering target-backing plate assembly for a 450-mm wafer, wherein the amount of warpage of the target developed during sputtering is 4 mm or less. Further provided is a method of manufacturing a sputtering target-backing plate assembly for a 450-mm wafer, the method comprising bonding a sputtering target material selected from copper, titanium, tantalum, nickel, cobalt, tungsten or alloys thereof with a backing plate made of copper, a copper alloy, an aluminum alloy, titanium or a titanium alloy at a temperature of 200 to 600°C, thereby the amount of warpage of the target developed during sputtering being 4 mm or less. An object of the present invention is to attempt to suppress detachment of a target from a backing plate and development of a crack by controlling development of warpage which occurs in a large sputtering target and to achieve uniform deposition properties.

## Description

### TECHNICAL FILED

The present invention relates to a large sputtering target which can be adapted for a 450-mm wafer.

### BACKGROUND ART

In manufacture of a semiconductor device, the costs for manufacturing an LSI Logic and a memory rapidly increase as a wiring width is becoming finer. The diameter of a wafer is required to be increased in accordance with the "Moore's law" in order to reduce the manufacturing cost thereof, and until now, increased diameters in every 10 years have brought innovation in the manufacturing technology.

A large 450-mm wafer is a driving force for a new innovation, and semiconductor manufacturers, wafer manufacturers and various device manufacturers have started efforts for achieving 450 mm. The shape of a sputtering target is largely dependent on a design by sputtering equipment manufacturer. If a wafer diameter is increased from the current 300 mm to 450 mm, a sputtering target compatible with it is expected to be half again the diameter and twice or more the weight even according to the simple proportional calculation.

Moreover, properties of a target required for achieving good deposition properties include 1) being pure and not containing a mediator serving as a source of particle generation and arcing; 2) having a uniform and fine structure in order to assure the uniformity of a film; 3) having a target surface cleaned and a strained layer removed in order to shorten the burn-in time; and the like.

In particular, since high energy is loaded to a target during sputtering, a sputtering surface of the target becomes very hot at several hundreds degrees Celsius, and disadvantageously the target itself will be deformed.

The present invention clarifies these problems, and further provides a proposal and an improvement in terms of maintenance of the above qualities and a manufacturing process when the diameter of a sputtering target is increased.

According to the conventional technology, several ideas for increasing a bonding strength between a target and a backing plate have been proposed. Those are listed below for reference.
1) Patent Literature 1 discloses a technology in which, for example, when bonding a target material of Al or an Al alloy with a backing plate, Ag or an Ag alloy is used as an insert material, and after it is interposed therebetween, solid phase diffusion is performed.
2) Patent Literature 2 discloses a technology in which unevenness is concentrically formed on bonding surfaces of both a sputtering target and a backing plate so that they are fitted to each other, and bonding is performed by the HIP method, the hot press method, the solid phase diffusion bonding method.
3) Patent Literature 3 discloses a technology in which when bonding a target material having a melting point of 1000°C or more with a backing plate, an insert material (Al, Cu, Ni and alloys thereof) having a melting point lower than that of the target is interposed therebetween to perform solid phase diffusion bonding.
4) Patent Literature 4 discloses a method in which a copper fine powder is included between a sputtering target and a backing plate, and bonding is performed at low temperature.
5) Patent Literature 5 discloses a technology in which an Al or Al alloy spacer is included between a sputtering target and a backing plate, and bonding is performed by explosion bonding or hot rolling.
6) Patent Literature 6 discloses sputtering equipment in which unevenness is provided on a cooling surface of a backing plate to increase surface area.
7) Patent Literature 7 discloses a technology in which diffusion bonding is performed after interposing an aluminum or aluminum alloy plate having a thickness of 0.8 mm or more as an insert material to manufacture a tantalum or tungsten-copper alloy backing plate assembly.
8) Patent Literature 8 discloses a technology in which diffusion bonding is performed after interposing an aluminum or aluminum alloy plate having a thickness of 0.8 mm or more as an insert material to manufacture a diffusion bonded assembly of highly pure cobalt and a copper alloy backing plate.
9) Patent Literature 9 describes a sputtering target in which a backing plate material 4 comprising two or more metal layers 2 and 3 is bonded together with a target material 5 by diffusion bonding or welding.
10) Patent Literature 10 describes that when performing solid phase diffusion bonding of a target and a backing plate via an insert material, either one side or both sides are subjected to planarizing treatment to give a roughness Ra of 0.01 to 3.0 µm.
11) Patent Literature 11 describes a bonding method in which an elastomer resin is used when bonding a target with a backing plate, and a metal mesh is included in the resin.
12) Patent Literature 12 describes that a copper, aluminum or an alloy foil thereof is sandwiched between a target and a backing plate, and then sputtering is performed.

In the above Patent Literatures, improvement in bonding methods have been attempted for enhancing the bonding strength between a sputtering target and a backing plate, but there exists no disclosure disclosing a problem of strain development when a target is increased in size and a method of solving it.

Patent Literature 1: Japanese Patent Laid-Open No. H6-172993
Patent Literature 2: Japanese Patent No. 4017198
Patent Literature 3: Japanese Patent Laid-Open No. H6-108246
Patent Literature 4: Japanese Patent Laid-Open No. S55-152109
Patent Literature 5: Japanese Patent Laid-Open No. H4-131374
Patent Literature 6: Japanese Patent Laid-Open No. H6-25839
Patent Literature 7: Japanese Patent No. 3905301
Patent Literature 8: Japanese Patent No. 3905295
Patent Literature 9: Japanese Patent Laid-Open No. 2001-295040
Patent Literature 10: Japanese Patent Laid-Open No. 2000-239838
Patent Literature 11: Japanese Patent Laid-Open No. 2006-33603
Patent Literature 12: Japanese Patent Laid-Open No. H11-189870

### DISCLOSURE OF INVENTION

### [Technical Problem]

An increase in the diameter of a shape of a sputtering target is required to support a 450-mm wafer. As a result of studying the effects of this on the quality of a target and the deformation of a target during deposition, no effect was observed due to an increased diameter in terms of properties important as the quality of a target such as material purity, structure, crystal orientation, surface texture of a target, and it was found that a target having the same quality as that of a target for a 300-mm wafer was able to be produced. However, in terms of the behavior of a target during deposition, warpage, which was insignificant in a target for a 300-mm wafer, was found to be at a non-negligible level in the case of one for a 450-mm wafer. An object of the present invention is to overcome this point.

### [Solution to Problem]

In order to solve the above problem, the following invention is provided.
1) A sputtering target-backing plate assembly for a 450-mm wafer, wherein the amount of warpage of the target developed during sputtering is 4 mm or less.
2) The sputtering target-backing plate assembly according to 1), wherein a variation in a mean crystal grain diameter at each part relative to a mean crystal grain diameter for the whole target is within ±20%.
3) The sputtering target-backing plate assembly according to 1), wherein a variation in the magnetic permeability at each part of the target is within ±5%.
4) The sputtering target-backing plate assembly according to any one of 1) to 3), wherein the target-backing plate assembly is brazed or diffusion bonded.
5) The sputtering target-backing plate assembly according to any one of 1) to 4), wherein a sputtering target is made of a material selected from copper, titanium, tantalum, tungsten or alloys thereof.
6) The sputtering target-backing plate assembly according to any one of 1) to 5), wherein a backing plate is made of copper, a copper alloy, an aluminum alloy, titanium or a titanium alloy.
7) A method of manufacturing a sputtering target-backing plate assembly for a 450-mm wafers, the method comprising bonding a sputtering target material selected from copper, titanium, tantalum, tungsten or alloys thereof with a backing plate made of copper, a copper alloy, an aluminum alloy, titanium or a titanium alloy at a temperature of 200 to 600°C, thereby the amount of warpage of the target developed during sputtering being 4 mm or less.

### [Advantageous Effects of Invention]

The present invention provides such significantly advantageous effects that, by controlling development of warpage which occurs in a large sputtering target, detachment of a target from a backing plate and development of a crack can be suppressed, uniform deposition can be achieved, a percent defective can be reduced, and the manufacturing efficiency can be increased.

### BRIEF DESCRIPTION OF DRAWINGS

[Fig. 1A] shows crystal structures of a copper target, a titanium target and a nickel target for each of a 300-mm wafer and a 450-mm wafer.
[Fig. 1B] shows crystal structures of a tantalum target and a tungsten target for each of a 300-mm wafer and for a 450-mm wafer.
[Fig. 2] shows warpage at the central portion of a copper target, a titanium target, a tantalum target, a nickel target, a cobalt target and a tungsten target (an oxygen free copper backing plate is used for each) for each of a 300-mm wafer and a 450-mm wafer.
[Fig. 3] shows warpage at the central portion of a target in a case where a copper-chromium alloy is used as a backing plate against a copper target.
[Fig. 4] shows 9 sampling positions in total at the outer periphery, r/2 and the center on orthogonal coordinates.

### DESCRIPTION OF EMBODIMENTS

As sputtering methods, already known are a coating method with sputtering equipment into which Ar gas is introduced such that voltage is applied to the both the target side used as a cathode and the substrate side used as an anode to eject a target material due to bombardment of the target by Ar ions and a substrate is coated with the material ejected from the target; or a coating method using so-called self-sputtering in which atoms sputtered from a target are ionized to further performing sputtering.

In many cases, a sputtering target is configured so that it is bonded with a backing plate, and the backing plate is cooled to prevent an abnormal temperature increase of the target, allowing stable sputtering.

In such sputtering equipment, the sputtering power tends to be increased so that the manufacturing efficiency is increased to enable high-speed sputtering. Usually, a material having a good thermal conductivity and certain strength is used as a backing plate.

Further, in sputtering equipment, a backing plate is cooled to absorb a thermal shock applied to a target through this backing plate. However, there is a limitation even in the aforementioned cooling. In particular, the problem is detachment or deformation of a target due to the difference in thermal expansion between the target and a backing plate.

Further, a target is subjected to erosion to produce unevenness in shape. When performing sputtering at high power, the following phenomena may occur: the thermal stress resulted from the heat during sputtering converges primarily at a concave portion, and the target may undergo deformation, resulting in a deteriorated uniformity; or arcing with a shield may occur to cause abnormal particle generation, and in an extreme case, the generation of plasma may stop.

In order to solve these problems, the following countermeasures may be envisioned: for example, the strength of a backing plate is enhanced; or the material is changed to reduce thermal stress. However, since there is a problem of compatibility with the material of a target, an appropriate solution has not been found to date.

In view of those described above, the present invention provides the following invention.

The sputtering target-backing plate assembly for a 450-mm wafer according to the present invention relates to a sputtering target-backing plate assembly in which the amount of warpage of a target developed during sputtering is 4 mm or less. The amount of warpage is preferably 3 mm or less.

The above sputtering target used for a 450-mm wafer is even larger than this, and the shape of the target reaches a size of nearly *φ* 600 mm. However, it is not limited to this numerical value (*φ* 600 mm), and there is no particular limitation as long as it can be used as a sputtering target for a 450-mm wafer. In general, it is possible to increase or decrease this numerical value within a range of 50%. Further, the maximum warpage of a target, which occurs near the center of the target, means that the maximum value of warpage is 4 mm or less (preferably 3 mm or less).

With regard to the uniformity of a film, variations in the mean grain diameter at each part relative to the mean crystal grain diameter for the whole target is to be within ±20% because in a case where the variations are more than ±20%, the difference in a sputtering speed at each part of the target becomes significant, resulting in poor uniformity.

Further, in the case of Cu, the mean crystal grain diameter at each part of a target is preferably 100 µm or less, and in the case of a Ti target, the mean crystal grain diameter at each part of a target is preferably 50 µm or less.

It is because in the case of coarse crystal grains such as those having a mean crystal grain diameter of more than 100 µm, 50 µm, respectively, the difference in discharge properties of atoms from each crystal grain becomes significant, and poor uniformity is prone to be resulted. The mean crystal grain diameter at each part of a target is particularly preferred to be 50 µm or less, 20 µm or less, respectively.

A target-backing plate is preferably bonded by brazing or diffusion bonding, and the adhesive strength of a bonding interface of an assembly is desirably 3 kgf/mm² or more.

Further, it is also possible to be bonded via an intervening layer of Ni, Zn, Ag, Cu, Al, Cr, In, Sn or alloys having these as a main component on a bonding interface. This is effective for controlling development of strain in a sputtering target-backing plate assembly.

Further, as a sputtering target, a material selected from copper, titanium, tantalum, nickel, cobalt, tungsten or alloys thereof may be used. Moreover, as a backing plate, those made of copper, a copper alloy, an aluminum alloy, titanium or a titanium alloy can be used.

As described in Examples below, in many cases, warpage of a target is resulted from the increase in temperature at a target surface due to the generation of plasma during sputtering. A backing plate is cooled, but the warpage is developed due to the difference in thermal expansion between the target and the backing plate.

Therefore, in order to effectively control warpage of a target, materials need to be selected and combined having small difference in the coefficient of thermal expansion between a target and a backing plate and having a high mechanical strength. Preferably, a backing plate having a good cooling efficiency is suitable for use. These combinations can be achieved by appropriately selecting from the materials described above.

In manufacture of a sputtering target-backing plate assembly for a 450-mm wafer, the amount of warpage of a target developed during sputtering can be controlled to be 3 mm or less by bonding the above sputtering target material selected from copper, titanium, tantalum, nickel, cobalt, tungsten or alloys thereof with a backing plate made of copper, a copper alloy, an aluminum alloy, titanium or a titanium alloy at a temperature of 200 to 600°C.

### [Examples]

The present invention will be described based on Examples (experimental examples). Note that Examples are presented for merely illustrative purposes, and the present invention shall in no way be limited to these. That is, other aspects or modifications included in the present invention are encompassed.

### (Production and evaluation of target for 450-mm wafer)

In order to determine if the quality of a large-sized target is maintained, a Cu, a Ti, a Ta, a Ni, a Co and a W target of *φ* 600 mm were produced. For the production of targets, each ingot or powder of Purity 6N-Cu, 4N5-Ti, 4N5-Ta, 5N-Ni, 5N-Co and 5N-W was used as a starting material.

A manufacturing process of each material was coordinated according to the conditions used for producing a target for 300-mm.

Note that in order to control variations in crystal grain diameters, conditions in which a uniform processing strain was applied upon rolling, and heat treatment conditions which allowed uniform temperature distribution were selected. For example, a Ti ingot was hot worked at 750°C, and then warm working was performed at a processing ratio of 1.5 at 400°C, and uniform heat treatment was then performed to the whole target at 600°C for 1 hour.

These conditions may somewhat be different depending on types and processing histories of materials, but by selecting basic conditions and then varying a range of the conditions based on these, the sputtering target suitable for the present invention can be produced.

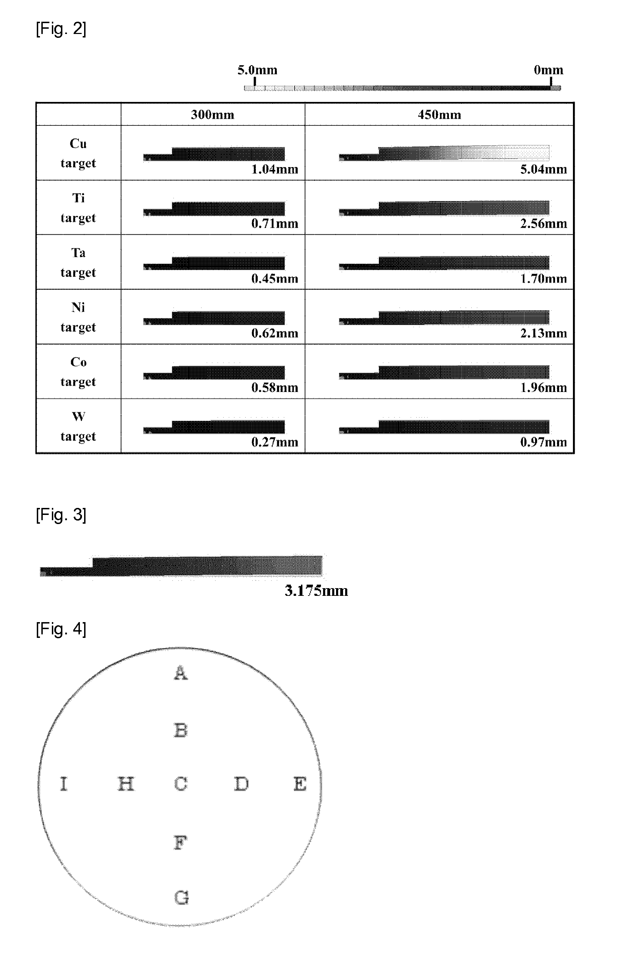

As shown in Fig. 4, each target was sampled at 9 positions in total at the outer periphery, r/2, and the center on orthogonal coordinates, and the structure evaluation was performed by optical microscope observation of an etching surface. Further, evaluation of crystal orientation by X-ray diffraction measurements was also performed.

### (Deformation behavior of target subjected to heat)

Since a target is irradiated with high energy during sputtering, a target surface is heated to high temperature. Meanwhile, since the side of a backing plate is water-cooled, a large temperature difference arises between the target surface and the water-cooled surface of the backing plate, and then warpage of the target will be developed due to the difference in thermal expansion. Accordingly, thermal effects (heating and cooling) to which a target is subjected during sputtering were reproduced, and under these situations, deformation behavior was investigated to compare a target adapted for a 300-mm wafer with a target adapted for a 450-mm wafer.

As materials for a target, 6N-Cu and 4N5-Ti were used, and as materials for a backing plate, oxygen free copper (OFC) and a Cu-Cr alloy were used. The shape of a target adapted for a 450-mm wafer was *φ* 600 mm x 12.7 mmt, and the shape of a backing plate was *φ* 750 mm x 12.7 mmt. The shape of a target adapted for a 300-mm wafer was *φ* 400 mm x 12.7 mmt, and the shape of a backing plate was *φ* 500 mm x 12.7 mmt.

For reference, note that sputtering is usually performed under the following conditions: the input power upon sputtering is 10 kW for one adapted for a normal 300-mm wafer, and 22.5 kW for one adapted for a 450-mm wafer which corresponds to the same power density as in the case for a 300-mm wafer, and further, ON-OFF of sputtering is performed as calculated after 15 cycles when ON: 10 seconds and OFF: 30 seconds are taken as one cycle. Similarly, sputtering is performed at a temperature of cooling water of 25°C under 3.0 atmospheric pressure.

### (Results above and discussion)

### (Shape and weight of sputtering target adapted for 450-mm wafer)

The shape of a sputtering target is largely dependent on a design by sputtering equipment manufacturers, but in the case of a target for a 300-mm wafer, the shape of a target is generally *φ* 400 mm to 450 mm x 6 mm to 12 mmt.

Here, if it is assumed that the shape of a target adapted for 300 mm is *φ* 400 mm, and is proportional to the diameter of the wafer, the shape of a target adapted for a 400-mm wafer is *φ* 600 mm, and the diameter of a backing plate is *φ* 750 mm.

The changes in weight for a Cu target, a Ti target, a Ta target, a Ni target, a Co target, a W target are shown in Table 1. Below, a case will be described in which the shape of a target adapted for a 450-mm wafer has a size of *φ* 600 mm.

In the case of targets for a 300-mm wafer, the weight is 50 kg or less (including the weight of a backing plate) for any material while in the case of targets adapted for a 450-mm wafer, the weight is nearly 100 kg. Therefore, a manufacturing process and a handling method when using a target need to be devised.

**[Table 1]**

| material | Weight | |
|---|---|---|
| | 300mm | 450mm |
| Cu | 40kg | 90kg |
| Ti | 21kg | 47 kg |
| Ta | 47kg | 106kg |
| Ni | 40kg | 90kg |
| Co | 40kg | 90kg |
| W | 39kg | 88kg |

### (Quality of sputtering target adapted for 450-mm wafer)

### (Purity)

The purity of a material for a target is an important factor which makes a significant impact on the properties of a deposited film. When alkaline metals such as Na and K and transition metals such as Fe, Cu and Ni are diffused in Si, the electrical properties change, and therefore device stabilization is compromised. Further, it is known that radioactive elements such as U and Th may cause a malfunction of a device due to α ray.

Refining (impurity removal) is performed in a step of electrolysis or vacuum melting in the case of materials such as Cu or Ti produced by the dissolving process. Since an ingot produced by vacuum melting usually has a weight enough for producing multiple targets, it is thought that there is no impact on purity even in the case of a target adapted for a 450-mm wafer. Analytical values of impurities in materials used herein for the tests are shown in Table 2.

**[Table 2]**

| Unit : ppm | | | | | | | | | | | | | |
|---|---|---|---|---|---|---|---|---|---|---|---|---|---|
| | Na | K | Fe | Ni | Ag | Ca | Cr | S | Al | U | Th | C | O |
| Cu target | <0.005 | < 0.01 | 0.03 | <0.001 | 0.13 | <0.005 | <0.002 | 0.007 | <0.001 | <0.1 | <0.1 | <1 | <1 |
| Ti target | <0.01 | < 0.01 | 4.2 | 1 | <0.02 | <0.05 | <0.1 | <10 | 0.8 | <0.1 | <0.1 | <10 | 190 |
| Ta target | <0.01 | <0.0.1 | <0.1 | <0.1 | - | - | <0.1 | <10 | <0.1 | <0.1 | <0.1 | 10 | 20 |
| Ni target | <0.01 | < 0.01 | <0.1 | - | <0.05 | <0.01 | <0.1 | <10 | < 0.01 | <0.1 | <0.1 | <10 | <10 |
| Co target | <0.01 | < 0.01 | 0.8 | 1.6 | <0.05 | <0.1 | <0.1 | <10 | <0.1 | <0.1 | <0.1 | <10 | <10 |
| W target | <0.01 | < 0.01 | <0.1 | <0.1 | - | <0.1 | <0.1 | <10 | <0.1 | <0.1 | <0.1 | 40 | 40 |

| | | | | | | | | | | | | | |
|---|---|---|---|---|---|---|---|---|---|---|---|---|---|
| ^{a} Unit of U and Th is ppb | | | | | | | | | | | | | |

### (Structure)

The structure and crystal orientation of a target make a large impact on a deposition speed and the uniformity of a film when sputtering. In particular, since a deposition speed differs depending on crystal plane orientations, the plane orientation of a target is preferred to be aligned, or preferred to be randomly and uniformly dispersed, and crystal grain diameters are demanded to be fine and uniform in order to perform deposition with good uniformity. Further, in the case of a magnetized target, the magnetic permeability thereof is also an affecting factor.

Therefore, a target adapted for a 450-mm wafer was produced according to the manufacturing conditions of a target for a 300-mm wafer, and a crystal structure, crystal orientation and magnetic permeability were evaluated. Note that in order to control variations in crystal grain diameters, conditions in which a uniform processing strain was applied upon rolling, and heat treatment conditions which allowed uniform temperature distribution were selected.

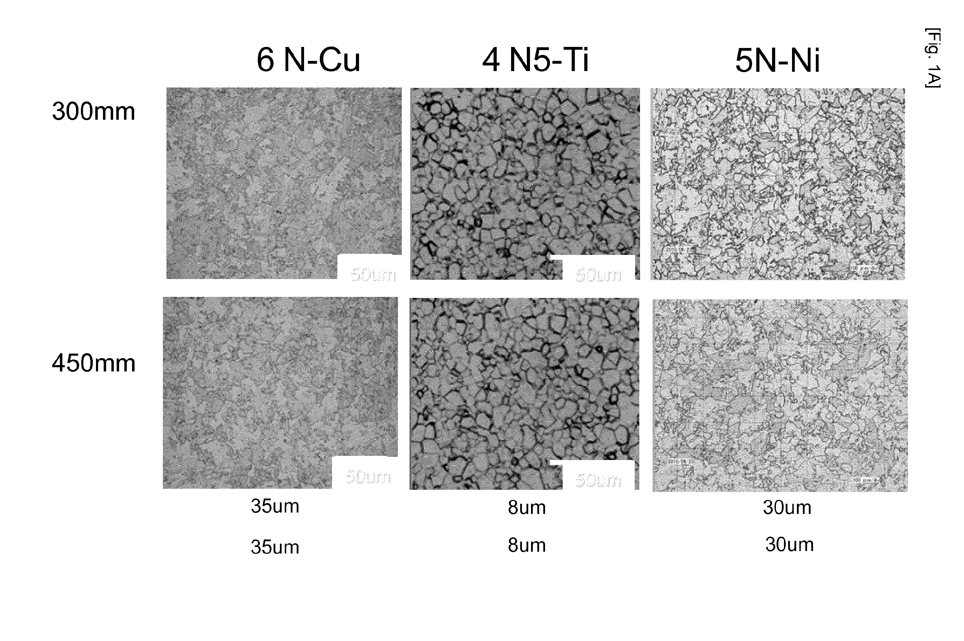

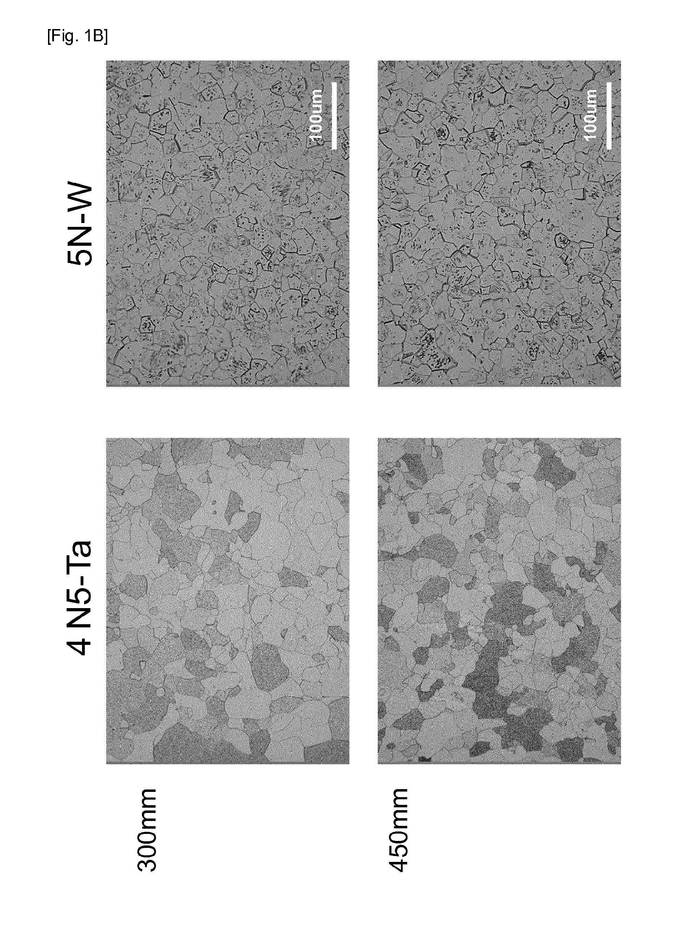

After etching a sample, optical microscope observation was performed. Results are shown in Figs. 1A and 1B. Note that the structures of targets for a normal 300-mm wafer are also shown in Fig. 1A for comparison. Note that the mean crystal grain diameter of a Cu target for a 300-mm wafer was 35 µm, the mean crystal grain diameter of a Ti target for a 300-mm wafer was 8 µm, the mean crystal grain diameter of a Ni target for a 300-mm wafer was 30 µm, and the mean crystal grain diameter of a W target for a 300-mm wafer was 20 µm.

As shown in Fig. 4, optical microscope observation was performed at the total 9 positions of A, B, C, D, E, F, G, H and I at the outer periphery, r/2, the center on orthogonal coordinates in a Cu target for a 450-mm wafer. Results were 35 µm, 37 µm, 35 µm, 33 µm, 36 µm, 34 µm, 35 µm, 34 µm and 36 µm, respectively. The variation was within ±20%, and the mean grain diameter was 35 µm. Note that measurements of the mean crystal grain size at each part were performed in accordance with the cutting method described in JIS-H0501.

Similarly, the crystal orientation was determined by XRD measurements, showing neither difference with the targets for a 300-mm nor a variation depending on sampling positions.

The crystal grain diameters were similarly measured in a Ti target for a 450-mm wafer. Results were 7 µm, 8 µm, 7 µm, 9 µm, 8 µm, 7 µm, 8 µm, 9 µm and 9 µm, respectively. The variation was within ±20%, and the mean grain diameter was 8 µm. Note that measurements of the mean crystal grain size at each part were performed in accordance with the cutting method described in JIS-H0501.

Similarly, the crystal orientation was determined by XRD measurements, showing neither difference with the targets for a 300-mm nor a variation depending on sampling positions.

The crystal grain diameters were similarly measured in a Ta target for a 450-mm wafer. Results were 90 µm, 92 µm, 89 µm, 90 µm, 93 µm, 92 µm, 88 µm, 89 µm and 90 µm, respectively. The variation was within ±20%, and the mean grain diameter was 90 µm. Note that measurements of the mean crystal grain size at each part were performed in accordance with the cutting method described in JIS-H0501.

Similarly, the crystal orientation was determined by XRD measurements, showing neither difference with the targets for a 300-mm nor a variation depending on sampling positions.

The crystal grain diameters were similarly measured in a Ni target for a 450-mm wafer. Results were 30 µm, 32 µm, 29 µm, 30 µm, 33 µm, 32 µm, 28 µm, 29 µm and 30 µm, respectively. The variation was within ±20%, and the mean grain diameter was 30 µm. Note that measurements of the mean crystal grain size at each part were performed in accordance with the cutting method described in JIS-H0501.

Similarly, the crystal orientation was determined by XRD measurements, showing neither difference with the targets for a 300-mm nor a variation depending on sampling positions.

As shown in Fig. 4, magnetic permeability measurements were performed at the total 9 positions of A, B, C, D, E, F, G, H and I at the outer periphery, r/2, the center on orthogonal coordinates in a Co target for a 450-mm wafer. Results were 6.1, 6.2, 6.0, 6.0, 6.3, 6.2, 6.0, 6.1 and 6.2, respectively. The mean magnetic permeability was 6.1, and the variation was within ±5%.

The crystal grain diameters were similarly measured in a W target for a 450-mm wafer. Results were 20 µm, 22 µm, 19 µm, 20 µm, 23 µm, 22 µm, 18 µm, 19 µm and 20 µm, respectively. The variation was within ±20%, and the mean grain diameter was 20 µm. Note that measurements of the mean crystal grain size at each part were performed in accordance with the cutting method described in JIS-H0501.

Similarly, the crystal orientation was determined by XRD measurements, showing neither difference with the targets for a 300-mm nor a variation depending on sampling positions.

Results described above reveal that it is possible to obtain a structure comparable with a currently used target for a 300-mm wafer even when the diameter of a target is increased to be adapted for a 450-mm wafer. However, in order to produce a target with a large-sized diameter by forging and/or rolling under the same conditions as a target for a 300-mm wafer, and larger power is required as compared to that used when producing a target for a 300-mm wafer, and off course, a facility corresponding to that needs to be required. Further, the uniformity in furnace temperature and a holding time need to be strictly adjusted in the heat treatment after rolling.

### (Cleanness, strain layer of target surface)

In a target surface after machining, fine processing debris, contaminants from a working tool and a processing strain layer near the surface remain. Contaminants on a target surface and a remaining strain layer as described above make a large impact on deposition properties in an early stage of sputtering, increasing the burn-in time until the properties are stabilized.

Therefore, cleaning of a target surface and removal of a strain layer are important for shortening the burn-in time. Methods of cleaning a target surface and removing a strain layer are usually performed by surface polishing and ultrasonic cleaning. Polishing conditions and ultrasonic cleaning conditions need to be optimized in a case where the diameter of a target is increased, but technical difficulties appear to be comparatively insignificant.

### (Deformation behavior of target)

Thermal effects (heating and cooling) to which a target was subjected during sputtering when using Cu, Ti, Ta, Ni, Co and W were used as a target, and oxygen free copper (OFC) was used for a backing plate material were reproduced, and deformation behavior, which means warpage behavior, under this situation was investigated. Results from warpage measurements of targets are shown in Fig. 2.

Meanwhile, warpage was about 1 mm at the central portion in the case of the Cu target for a 300-mm wafer while warpage was expanded to about 5 mm in the case of the target for a 450-mm wafer. Warpage during sputtering causes variations in the distance between a target and a substrate, making an impact on deposition properties. Below, the amount of warpage is described for each target.

In the case of the Ti targets, it was about 0.7 mm at the central portion for a 300-mm wafer while it was about 2.6 mm for a 450-mm wafer.

In the case of the Ta targets, it was about 0.5 mm at the central portion for a 300-mm wafer while it was about 1.7 mm for a 450-mm wafer.

In the case of the Ni targets, it was about 0.6 mm at the central portion for a 300-mm wafer while it was about 2.1 mm for a 450-mm wafer.

In the case of the Co targets, it was about 0.6 mm at the central portion for a 300-mm wafer while it was about 2.0 mm for a 450-mm wafer.

In the case of the W targets, it was about 0.3 mm at the central portion for a 300-mm wafer while it was about 1.0 mm for a 450-mm wafer.

Further, a large warpage will destroy bonding between a target and a backing plate, leading to a risk of detachment of the target. As shown above, there is a possibility that a phenomenon, which is not a problem in the case of those adapted for a 300-mm wafer, will be exposed as a new problem when the diameter increases in order to be adapted for a 450-mm wafer.

Warpage of a target developed during sputtering is caused by increased temperature of a target surface due to collisions with plasma-ionized Ar grains and by the difference in the coefficient of thermal expansion between a target material and a backing plate material.

In order to control the development of warpage, it is effective to use a backing plate material having a small difference in the coefficient of thermal expansion with a target material and having a high mechanical strength. The amount of warpage at the center portion when using a Cu-Cr alloy having a mechanical strength higher than that of OFC as a backing plate material used above was about 3.2 mm, demonstrating that warpage was well controlled as compared with a case in which OFC was used.

### INDUSTRIAL APPLICABILITY

The present invention provides such significantly advantageous effects that, by controlling development of warpage which occurs in a large sputtering target, detachment of a target from a backing plate and development of a crack can be suppressed, uniform deposition can be achieved, a percent defective can be reduced, and the manufacturing efficiency can be increased; and therefore is extremely useful in industry.

## Claims

1. A sputtering target-backing plate assembly for a 450-mm wafer, wherein the amount of warpage of the target developed during sputtering is 4 mm or less.

2. The sputtering target-backing plate assembly according to claim 1, wherein a variation in a mean crystal grain diameter at each part relative to a mean crystal grain diameter for the whole target is within ±20%.

3. The sputtering target-backing plate assembly according to claim 1, wherein a variation in the magnetic permeability at each part of the target is within ±5%.

4. The sputtering target-backing plate assembly according to any one of claims 1 to 3, wherein the target-backing plate assembly is brazed or diffusion bonded.

5. The sputtering target-backing plate assembly according to any one of claims 1 to 4, wherein a sputtering target is made of a material selected from copper, titanium, tantalum, nickel, cobalt, tungsten or alloys thereof.

6. The sputtering target-backing plate assembly according to any one of claims 1 to 5, wherein a backing plate is made of copper, a copper alloy, an aluminum alloy, titanium or a titanium alloy.

7. A method of manufacturing a sputtering target-backing plate assembly for a 450-mm wafer, the method comprising bonding a sputtering target material selected from copper, titanium, tantalum, nickel, cobalt, tungsten or alloys thereof with a backing plate made of copper, a copper alloy, an aluminum alloy, titanium or a titanium alloy at a temperature of 200 to 600°C, thereby the amount of warpage of the target developed during sputtering being 4 mm or less.
